# EUROPÄISCHE PATENTSCHRIFT

(11) **EP 2 268 118 B1**
(45) Veröffentlichungstag und Bekanntmachung des Hinweises auf die Patenterteilung: **08.08.2018**
(21) Anmeldenummer: 10167286.3
(22) Anmeldetag: 25.06.2010
(51) Int. Cl.: H05K 9/00, H02P 7/29

(54) **Türanlage**
Door system
Installation de porte

(30) Priorität: 26.06.2009 DE 102009027239
(43) Veröffentlichungstag der Anmeldung: 29.12.2010
(73) Patentinhaber: GEZE GmbH, 71229 Leonberg (DE)
(72) Erfinder: Dr. Hucker, Matthias, 76359, Marxzell (DE); Kiesel, Rainer, 89160, Dornstadt (DE); Katz, Eugen, 71139, Ehningen (DE)

(56) Entgegenhaltungen:
- EP-A2- 1 067 669
- WO-A1-2008/141407
- DE-A1- 19 860 153
- DE-A1-102006 014 309
- DE-B3-102005 028 058
- JP-A- 2005 199 781
- US-A1- 2007 003 258

## Beschreibung

Die Erfindung betrifft eine Türanlage nach dem Oberbegriff des Patentanspruchs 1.

Aus der DE 10 2005 028 058 A1 ist eine Türanlage mit einer automatischen Antriebseinrichtung bekannt. Eine automatische Antriebseinrichtung dient zum Antrieb des Türflügels, wobei die Antriebseinrichtung eine elektronische Steuerungseinrichtung und mindestens einen elektrischen Antriebsmotor aufweist. Die Steuerungseinrichtung gibt ein pulsweitenmoduliertes Signal zur Ansteuerung des Antriebsmotors ab. Die Schaltfrequenz des pulsweitenmodulierten Signals ist bei derartigen Türanlagen in der Steuerungseinrichtung fest eingestellt, z.B. auf 20 kHz, und somit nicht änderbar.

Selbst beim Vorhandensein abschirmender Maßnahmen kann es nicht ausgeschlossen werden, dass von der Steuerungseinrichtung hochfrequente Strahlung in die nähere Umgebung der Türanlage emittiert wird. Diese Strahlung kann den Betrieb elektronischer Einrichtungen, welche sich in der Nähe der Türanlage befinden, stören. Beispielsweise sind Warensicherungsanlagen bekannt, welche eine Arbeitsfrequenz von z.B. 60 kHz aufweisen, so dass bei einer Schaltfrequenz des pulsweitenmodulierten Signals der Steuerungseinrichtung von 20 kHz die dritte Oberwelle der Schaltfrequenz exakt in dem Arbeitsbereich der Warensicherungsanlage liegt und somit zu unerwünschten, störenden Beeinflussungen der Warensichierungsanlage führen kann.

Aus der DE 198 60 153 A1 ist ein Verfahren sowie eine Vorrichtung zum Unterdrücken von durch eine elektrische Maschine verursachten Störungen eines Autoradios bekannt. Die Schaltfrequenz des pulsweitenmodulierten Signals der elektrischen Maschine wird automatisch so angepasst, dass eine Störung des Autoradios weitestgehend ausgeschlossen ist. Eine ähnliche Anordnung ist auch aus der DE 10 2006 014 309 A1 bekannt, wobei hier die Schaltfrequenz der elektrischen Maschine nicht fest, sondern in bestimmten Mustern variierbar ist.

Der Erfindung liegt die Aufgabe zugrunde, eine Türanlage zu schaffen, welche sich durch hohe Störfreiheit auszeichnet.

Die Aufgabe wird durch die Merkmale des Patentanspruchs 1 gelöst.

Die Unteransprüche bilden vorteilhafte Ausgestaltungsmöglichkeiten der Erfindung.

Es ist eine Einstelleinrichtung vorgesehen, durch welche die Schaltfrequenz des pulsweitenmodulierten Signals einstellbar ist.

Hierdurch wird eine hohe Störfreiheit erreicht, da die Schaltfrequenz des pulsweitenmodulierten Signals an die Arbeitsfrequenzen elektronischer Geräte anpassbar ist, welche sich in der Nähe der Türanlage befinden. Beispielsweise kann die Schaltfrequenz des pulsweitenmodulierten Signals so eingestellt werden, dass sie und/oder ihre stärksten Oberwellen nicht im Bereich der Arbeitsfrequenz eines in der Nähe der Türanlage befindlichen, elektronischen Geräts liegt, womit eine störende Beeinflussung dieses Geräts verhindert wird. Selbstverständlich gilt dies auch umgekehrt, d.h. auch eine Beeinflussung der Türanlage durch andere Geräte wird verhindert.

Die Einstellung der Schaltfrequenz des pulsweitenmodulierten Signals kann durch eine hierzu autorisierte Person erfolgen. Die Einstelleinrichtung weist hierzu eine Anzeigeeinrichtung und eine Eingabeeinrichtung auf, durch welche der Wert der Schaltfrequenz anzeigbar und bei Bedarf änderbar ist.

Alternativ oder zusätzlich kann die Einstelleinrichtung eine Schnittstelle aufweisen, durch welche die Schaltfrequenz auch entfernt von der Türanlage anzeigbar und bei Bedarf änderbar ist. Beispielsweise kann die Schnittstelle den Anschluss eines kabelgebundenen Service-Terminals ermöglichen, oder eine Sender- / Empfängereinrichtung zur drahtlosen Kommunikation mit einer Fernsteuereinrichtung aufweisen, z.B. über Infrarot oder Ultraschall.

Die Einstelleinrichtung ist in einem Programmschalter der Antriebseinrichtung integriert. Hierdurch sind keine separaten Bauelemente für die Einstelleinrichtung notwendig.

Die Einstelleinrichtung kann eine Berechtigungsprüfungseinrichtung aufweisen, durch welche eine Betätigung der Einstelleinrichtung nur berechtigten Personen ermöglicht wird. Die Berechtigtenschalteinrichtung kann eine Codeeingabeeinrichtung, ein Schloss, einen Fingerabdrucksensor oder dergleichen aufweisen.

Eine konkrete Anwendung der Vorteile der erfindungsgemäßen Türanlage kann beispielsweise erfolgen, wenn im Bereich des durch die Türanlage definierten Durchgangsbereichs eine Warensicherungsanlage angeordnet ist. Derartige Warensicherungsanlagen weisen üblicherweise eine Überwachungseinrichtung auf, welche eine bestimmte Arbeitsfrequenz aufweist. Um eine Störung der Warensicherungsanlage zu vermeiden, ist die Schaltfrequenz der Antriebseinrichtung an die Arbeitsfrequenz der Warensicherungsanlage so anpassbar, dass die Schaltfrequenz und/oder ihre Oberwellen nicht im Bereich der Arbeitsfrequenz der Warensicherungsanlage liegt und somit eine Beeinflussung der Warensicherungsanlage durch die Antriebseinrichtung vermieden wird.

Im Nachfolgenden wird ein Ausführungsbeispiel in der Zeichnung anhand der Figuren näher erläutert.

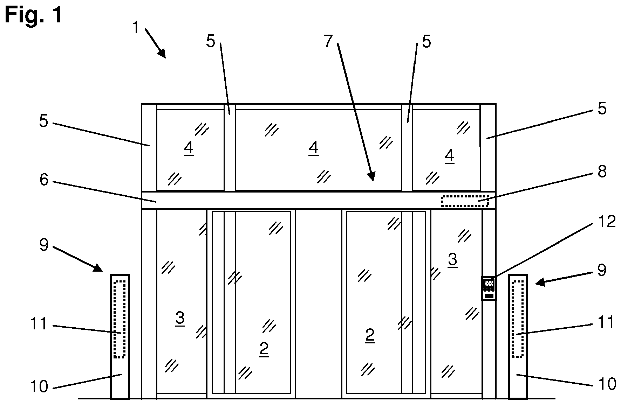

In Fig. 1 ist eine Türanlage 1 in schematischer Frontansicht dargestellt. Die Türanlage 1 weist zwei gegenläufig angetriebene als Schiebeflügel ausgebildete Türflügel 2 auf, deren Durchgangsbereich seitlich von je einem Festfeld 3 begrenzt wird. Oberhalb der Türflügel 2 und der Festfelder 3 verläuft ein Riegel 6, welcher Teil einer Pfosten-Riegel-Konstruktion ist und sich auf mehreren Pfosten 5 abstützt. Im Bereich des Riegels 6 ist eine - hier nicht dargestellte - Führungseinrichtung, beispielsweise eine Laufschiene angeordnet, in welcher die Türflügel 2, beispielsweise durch Rollenwagen, verschiebbar geführt sind. Der obere Bereich der Türanlage wird durch mehrere Oberlichter 4 gebildet.

Im Bereich des Riegels 6 ist eine Antriebseinrichtung 7 angeordnet, welche einen - hier nicht dargestellten - elektrischen Antriebsmotor zum Antrieb der Türflügel 2 aufweist. Der Antriebsmotor wird durch eine Steuerungseinrichtung 8 angesteuert, indem sie ein pulsweitenmoduliertes Signal abgibt. Derartige PWM-Signale weisen eine Schaltfrequenz auf, d.h. eine bestimmte Anzahl von Spannungsimpulsen pro Sekunde.

In der Nähe der Türanlage 1 ist eine Warensicherungsanlage 9 angeordnet, welche seitlich des Durchgangsbereichs der Türanlage 1 jeweils eine Säule 10 aufweist, wobei in den Säulen 10 jeweils eine Überwachungseinrichtung 11 integriert ist. Die Überwachungseinrichtung 11 dient zum Erkennen von Warensicherungsetiketten, - klips oder dergleichen und weist hierzu eine bestimmte Arbeitsfrequenz auf.

Um eine Störung der Warensicherungsanlage 9 zu vermeiden, ist die Schaltfrequenz der Antriebseinrichtung 7 an die Arbeitsfrequenz der Warensicherungsanlage 9 so anpassbar, dass die Schaltfrequenz und/oder ihre stärksten Oberwellen nicht im Bereich der Arbeitsfrequenz der Warensicherungsanlage 9 liegt und so-mit eine gegenseitige Beeinflussung der Warensicherungsanlage 9 und der Antriebseinrichtung 7 vermieden wird.

Zur Einstellung der Schaltfrequenz des pulsweitenmodulierten Signals der Antriebseinrichtung 7 durch eine hierzu autorisierte Person ist im Bereich der Türanlage 1 eine Einstelleinrichtung 12 vorgesehen. Die Einstelleinrichtung 12 weist hierzu eine Anzeigeeinrichtung und eine Eingabeeinrichtung auf, durch welche der Wert der Schaltfrequenz anzeigbar und bei Bedarf änderbar ist. Dabei ist die Einstelleinrichtung 12 in einem ohnehin vorhandenen Programmschalter der Antriebseinrichtung 7 integriert, wodurch dann keine separaten Eingabe- und/oder Anzeigeelemente für die Einstelleinrichtung 12 notwendig sind.

Die Einstelleinrichtung 12 kann eine Berechtigungsprüfungseinrichtung aufweisen, durch welche eine Betätigung der Einstelleinrichtung 12 nur berechtigten Personen ermöglicht wird. Die Berechtigtenschalteinrichtung kann eine Codeeingabeeinrichtuna. ein Schloss. einen Finaerabdrucksensor oder dergleichen auf-weisen.

Alternativ oder zusätzlich kann die Einstelleinrichtung 12 eine Schnittstelle aufweisen, durch welche die Schaltfrequenz auch entfernt von der Türanlage 1 anzeigbar und bei Bedarf änderbar ist. Die Schnittstelle kann als kabelgebundene oder drahtlose Schnittestelle ausgebildet sein so dass die Anzeige und ggf Änderung der Schaltfrequenz über ein Service-Terminal oder eine andere Fernsteuereinrichtung erfolgen kann.

Der Gegenstand der Erfindung ist nicht auf die dargestellte Schiebetüranlage begrenzt. Auch andere Arten von Türanlagen 1, z.B. Dreh- oder Karusselltüranlagen, sind denkbar.

Selbstverständlich kann die erfindungsgemäße Türanlage 1, alternativ oder zusätzlich zu der dargestellten Warensicherungsanlage 9, auch in räumlicher Nähe zu anderen elektronischen Geräten ohne gegenseitige störende Beeinflussung betrieben werden.

### Liste der Referenzzeichen

- 1: Türanlage
- 2: Türflügel
- 3: Festfeld
- 4: Oberlicht
- 5: Pfosten
- 6: Riegel
- 7: Antriebseinrichtung
- 8: Steuerungseinrichtung
- 9: Warensicherungsanlage
- 10: Säule
- 11: Überwachungseinrichtung
- 12: Einstelleinrichtung

## Patentansprüche

1. Türanlage (1) mit mindestens einem beweglichen Türflügel (2), mit einer automatischen Antriebseinrichtung (7) zum Antrieb des Türflügels (2),
wobei die Antriebseinrichtung (7) eine elektronische Steuerungseinrichtung (8) und mindestens einen elektrischen Antriebsmotor aufweist, und wobei die Steuerungseinrichtung (8) ein pulsweitenmoduliertes Signal zur Ansteuerung des Antriebsmotors abgibt,
**dadurch gekennzeichnet,**
**dass** eine Einstelleinrichtung vorgesehen ist, wobei die Einstelleinrichtung (12) in einem Programmschalter der Antriebseinrichtung (7) integriert ist, und wobei die Einstelleinrichtung (12) eine Anzeigeeinrichtung und eine Eingabeeinrichtung aufweist, durch welche der Wert der Schaltfrequenz des pulsweitenmodulierten Signals anzeigbar und bei Bedarf änderbar ist.

2. Türanlage nach Anspruch 1,
**dadurch gekennzeichnet, dass** die Einstelleinrichtung (12) eine Schnittstelle aufweist.

3. Türanlage nach Anspruch 1,
**dadurch gekennzeichnet, dass** die Einstelleinrichtung (12) eine Berechtigungsprüfungseinrichtung aufweist,

4. Türanlage nach Anspruch 1,
**dadurch gekennzeichnet, dass** die Schaltfrequenz der Antriebseinrichtung (7) an die Arbeitsfrequenz eines in der Nähe der Türanlage (1) befindlichen elektronischen Geräts so anpassbar ist, dass eine gegenseitige Beeinflussung des elektronischen Geräts und der Antriebseinrichtung (7) vermieden wird.

## Claims

1. Door system (1) comprising at least one movable door leaf (2), comprising an automatic drive device (7) for driving the door leaf (2), wherein the drive device (7) has an electronic control device (8) and at least one electrical drive motor, and wherein the control device (8) outputs a pulse-width-modulated signal for actuating the drive motor,
**characterized in that**
a setting device is provided, wherein the setting device (12) is integrated in a program switch of the drive device (7), and wherein the setting device (12) has a display device and an input device, by means of which the value of the switching frequency of the pulse-width-modulated signal can be displayed and, if required, can be changed.

2. Door system according to Claim 1, **characterized in that** the setting device (12) has an interface.

3. Door system according to Claim 1, **characterized in that** the setting device (12) has an authorization check device.

4. Door system according to Claim 1, **characterized in that** the switching frequency of the drive device (7) can be adjusted to the operating frequency of an electronic unit located near the door system (1) in such a way that reciprocal influencing of the electronic unit and the drive device (7) is prevented.

## Revendications

1. Installation de porte (1) comportant au moins un vantail de porte mobile (2) et un dispositif d'entraînement automatique (7) destiné à entraîner le vantail de porte (2), dans lequel le moyen d'entraînement (7) comporte un dispositif de commande électronique (8) et au moins un moteur d'entraînement électrique, et dans lequel le dispositif de commande (8) délivre un signal modulé en largeur d'impulsion destiné à commander le moteur d'entraînement, **caractérisée en ce qu'**il est prévu un dispositif de réglage, dans lequel le dispositif de réglage (12) est intégré à un commutateur de programme du dispositif d'entraînement (7), et dans lequel le dispositif de réglage (12) comporte un dispositif d'affichage et un dispositif de saisie au moyen duquel la valeur de la fréquence de commutation du signal modulé en largeur d'impulsion peut être affichée et modifiée selon les besoins.

2. Installation de porte selon la revendication 1, **caractérisée en ce que** le dispositif de réglage (12) comporte une interface.

3. Installation de porte selon la revendication 1, **caractérisée en ce que** le dispositif de réglage (12) comporte un dispositif de vérification d'autorisation.

4. Installation de porte selon la revendication 1, **caractérisée en ce que** la fréquence de commutation du dispositif d'entraînement (7) peut être adaptée à la fréquence de fonctionnement d'un appareil électronique situé à proximité de l'installation de porte (1) de manière à éviter une influence mutuelle entre l'appareil électronique et le dispositif d'entraînement (7) .
